# EUROPEAN PATENT APPLICATION

(11) **EP 4 167 284 A2**
(43) Date of publication of application: **19.04.2023**
(21) Application number: 22196063.6
(22) Date of filing: 16.09.2022
(51) Int. Cl.: H01L 25/10, H01L 25/18, H01L 23/00

(54) **SEMICONDUCTOR PACKAGE WITH TSV DIE**

(30) Priority: 13.10.2021 US 202163255027 P; 06.09.2022 US 202217938911
(71) Applicant: MediaTek Inc., Hsin-Chu 300 (TW)
(72) Inventor: YANG, Ya-Lun, 30078 Hsinchu City (TW); WU, Wen-Chou, 30078 Hsinchu City (TW); KUO, Che-Hung, 30078 Hsinchu City (TW)
(74) Representative: Hoefer & Partner Patentanwälte mbB

(57) **Abstract**

A semiconductor package includes a bottom package (10) having a substrate (100) and a semiconductor die (101) mounted on a top surface (100a) of the substrate (100). The semiconductor die (101) has an active surface (101a) and a rear surface (101b) coupled to the top surface (100a) of the substrate (100). The semiconductor die (101) comprises through silicon vias (110). A top package (30) is stacked on the bottom package (10). The top package (30) comprises a memory component (300). A middle re-distribution layer, RDL, structure (200) is disposed between the top package (30) and the bottom package (10). The active surface (101a) of the semiconductor die (101) is directly connected to the middle RDL structure (200) through connecting elements (BP). The memory component (300) is electrically connected to the substrate (100) via the interconnect structures (220) of the middle RDL structure (200) and the through silicon vias (110) of the semiconductor die (101).

## Description

### Cross Reference to Related Applications

This application claims the benefit of U.S. Provisional Application No. 63/255,027, filed on October 13th, 2021. The content of the application is incorporated herein by reference.

### Background

The present disclosure relates generally to the field of semiconductor packaging. More particularly, the present disclosure relates to a semiconductor package with a through-silicon-via (TSV) logic die.

More and more high-end products have adopted package-on-package (PoP) such as High-Bandwidth PoP (HBPoP) or Fan-Out PoP. In conventional PoP design, the logic die and the memory dies are separately packaged. Testability of individual dies is improved because the logic and memory dies can be separately tested, and only known-good-dies, which pass the tests, are packaged. This keeps costs low and allows the ability to customize memory needs for particular processors.

However, there are limitations in conventional PoP design that can create issues in certain implementations. For example, in a conventional Fan-Out PoP, signals are transmitted through relatively longer paths, which are generally constructed by bond wires, the wire-bond fingers, and the substrate traces to DRAM balls of the DRAM package, the connection between the DRAM balls to through mold vias (TMVs), and the connection between the TMVs to the semiconductor die, which limits the application for higher speed and higher bandwidth memory.

There is a constant need in this industry to provide an improved PoP having shorter signal connection path between the mobile AP and the high-speed DDR DRAM package in mobile applications.

### Summary

One object of the present disclosure is to provide an improved semiconductor package with vertically integrated memory die and through-silicon-via (TSV) logic die, which supports very wide I/O interfaces and enables high-bandwidth memory access. Semiconductor packages according to the invention are defined in the independent claims. The dependent claims define preferred embodiments thereof.

One aspect of the invention provides a semiconductor package including a bottom package comprising a substrate and a semiconductor die mounted on a top surface of the substrate. The semiconductor die has an active surface and a rear surface coupled to the top surface of the substrate. The semiconductor die comprises through silicon vias. The semiconductor die and the top surface of the substrate are encapsulated by a first molding compound. A top package is stacked on the bottom package. The top package comprises a memory component. A middle re-distribution layer (RDL) structure is disposed between the top package and the bottom package. The active surface of the semiconductor die is directly connected to the middle RDL structure through connecting elements. The middle RDL structure comprises dielectric layers and interconnect structures. The memory component is electrically connected to the substrate via the interconnect structures of the middle RDL structure and the through silicon vias of the semiconductor die.

Preferably, the semiconductor die comprises a central processing unit (CPU), a graphics processing unit (GPU), a system-on-a-chip (SOC), a field-programmable gate array (FPGA), a microcontroller unit (MCU), a power management integrated circuit (PMIC) die, a radio frequency (RF) die, a sensor die, a micro-electro-mechanical-system (MEMS) die, or a signal processing die.

Preferably, the substrate is a re-distribution layer (RDL) substrate.

Preferably, the substrate comprises a plurality of connection pads disposed on or near the top surface of the substrate, a plurality of conductive traces interconnecting the plurality of connection pads with a plurality of ball pads distributed on or near a bottom surface of the substrate.

Preferably, a plurality of solder balls is disposed on the plurality of ball pads, respectively.

Preferably, power or ground to the memory component is provided through the through silicon vias.

Preferably, the connecting elements comprises micro-bumps.

Preferably, a gap between the middle RDL structure and the active surface of the semiconductor die is filled with an underfill material.

Preferably, a plurality of through mold vias is disposed in the first molding compound.

Preferably, the memory component is a High-Bandwidth Memory (HBM) including multiple DRAM dies stacked on one another, wherein the stacked DRAM dies are vertically interconnected.

Preferably, the memory component further comprises a DRAM base.

Preferably, the DRAM base is electrically coupled to the middle RDL structure, wherein power or ground signals are transmitted to the solder balls on the bottom surface of the substrate via a conductive path comprised of the interconnect structures of the middle RDL structure, the connecting elements, the through silicon vias of the semiconductor die, and the conductive traces of the substrate.

Preferably, the semiconductor package further comprises a second molding compound encapsulating the memory component.

Preferably, the memory component is aligned with the semiconductor die and disposed at or near the center of the semiconductor die when viewed from above.

Preferably, a sidewall of the top package is vertically flush with a sidewall of the bottom package.

Preferably, the top package further comprises a dummy die.

Another aspect of the invention provides a semiconductor package including a substrate and a semiconductor die mounted on a top surface of the substrate in a flip-chip manner. The semiconductor die has an active surface and a passive rear surface. The semiconductor die comprises through silicon vias. A memory component is directly mounted on the semiconductor die. The memory component is electrically connected to the semiconductor die through connecting elements. The semiconductor die and the memory component are packaged in a unified molding compound.

Preferably, the substrate comprises a plurality of conductive traces interconnecting the active surface of the semiconductor die with ball pads distributed on or near a bottom surface of the substrate.

Preferably, solder balls are disposed on the ball pads, respectively.

Preferably, power or ground signals are transmitted to the solder balls on the bottom surface of the substrate via a conductive path comprised of the connecting elements, the through silicon vias of the semiconductor die, and the conductive traces of the substrate.

Preferably, the memory component is a High-Bandwidth Memory (HBM) including multiple DRAM dies stacked on one another, wherein the stacked DRAM dies are vertically interconnected by through silicon vias and microbumps.

Preferably, the memory component further comprises a DRAM base.

Preferably, the memory component is offset from a center of the semiconductor die.

Preferably, the semiconductor package further comprises a dummy die disposed on the semiconductor die, which is packaged in the unified molding compound.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary semiconductor package with a "face-up" TSV die in accordance with one embodiment of the disclosure;
FIG. 2 is a schematic, cross-sectional diagram showing a variant semiconductor package with a "face-up" TSV die and a dummy die in accordance with another embodiment of the disclosure;
FIG. 3 is a schematic, cross-sectional diagram showing an exemplary semiconductor package with a "face-down" TSV die in accordance with still another embodiment of the disclosure; and
FIG. 4 is a schematic, cross-sectional diagram showing an exemplary semiconductor package with a "face-down" TSV die and a dummy die in accordance with still another embodiment of the disclosure.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

Packaging of an integrated circuit (IC) chip can involve attaching the IC chip to a substrate (e.g., a packaging substrate) which, among other things, provides mechanical support and electrical connections between the chip and other electronic components of a device. Substrate types include, for example, cored substrates, including thin core, thick core (laminate bismaleimide-triazine resin (BT resin) or FR-4 type fibrous board material), and laminate core, as well as coreless substrates. Cored package substrates, for example, can be built up layer by layer around a central core, with layers of conductive material (usually copper) separated by layers of insulating dielectric, with interlayer connections being formed with through holes or microvias (vias).

High Bandwidth Memory (HBM) is a high-speed computer memory interface for 3D-stacked synchronous dynamic random-access memory (SDRAM). HBM achieves higher bandwidth while using less power in a substantially smaller form factor than DDR4 or GDDR5. This is achieved by stacking up to eight DRAM dies and an optional base die which can include buffer circuitry and test logic. The stack is often connected to the memory controller on a GPU or CPU through a substrate, such as a silicon interposer. Alternatively, the memory die could be stacked directly on the CPU or GPU chip. Within the stack the die are vertically interconnected by through-silicon vias (TSVs) and microbumps. The HBM DRAM uses wide-interface architecture to achieve high-speed, low-power operation.

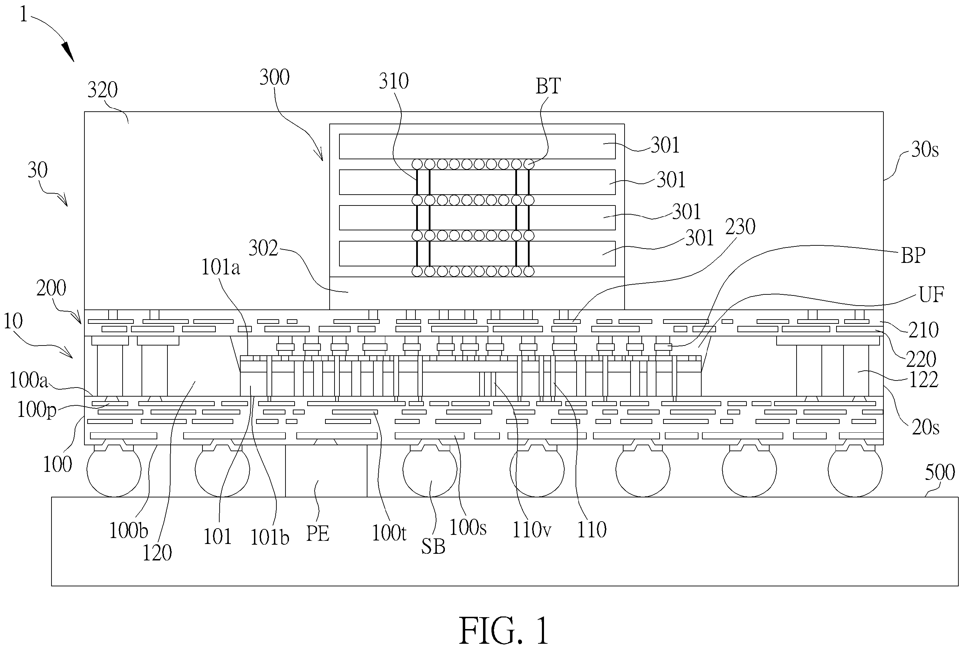

FIG. 1 is a schematic, cross-sectional diagram showing an exemplary semiconductor package 1 with a TSV die in accordance with one embodiment of the disclosure. Preferably, the semiconductor package 1 may serve as a three-dimensional (3D) semiconductor package assembly including at least two vertically stacked semiconductor dies or chip packages. As shown in FIG. 1, the semiconductor package 1 comprises a bottom package 10 and a top package 30 stacked on the bottom package 10. Preferably, for example, the bottom package 10 may comprise a substrate 100 and a semiconductor die (TSV die) 101, such as a logic die, mounted on a top surface (die-attach surface) 100a of the substrate 100. The semiconductor die 101 and the top surface 100a of the substrate 100 may be encapsulated by a molding compound 120. Preferably, the semiconductor package 1 may be mounted on a printed circuit board 500 or any carrier substrate known in the art.

Preferably, for example, the semiconductor die 101a may be a central processing unit (CPU), a graphics processing unit (GPU), a system-on-a-chip (SOC), a field-programmable gate array (FPGA), a microcontroller unit (MCU), a power management integrated circuit (PMIC) die, a radio frequency (RF) die, a sensor die, a micro-electro-mechanical-system (MEMS) die, or a signal processing die (e.g., digital signal processing (DSP) die), but is not limited thereto. Preferably, the bottom package 10 may include one or more logic dies.

Preferably, for example, the substrate 100 may be a circuit board and may be formed of polymer materials such as bismaleimide triazine (BT) laminates and/or build-up films known in the art. Preferably, the substrate 100 may be a re-distribution layer (RDL) substrate that has a thinner thickness. It is to be understood that the substrate 100 may be a single layer or a multi-layer structure. Preferably, for example, the substrate 100 may comprise a plurality of connection pads lOOp disposed on or near the top surface 100a of the substrate 100. Preferably, for example, the substrate 100 may comprise a plurality of conductive traces lOOt interconnecting the plurality of connection pads lOOp with a plurality of ball pads 100s distributed on or near a bottom surface 100b of the substrate 100. Solder balls SB are disposed on the ball pads 100s, respectively. Preferably, at least one passive device PE may be mounted on the bottom surface 100b of the substrate 100 using surface mount technique (SMT).

Preferably, the semiconductor die 101 is mounted on the top surface 100a of the substrate 100. Preferably, the semiconductor die 101 has a top surface (or active surface) 101a and a passive rear surface 101b. The circuit elements such as transistors are fabricated on or near the top surface 101a of the semiconductor die 101. Preferably, the passive rear surface 101b of the semiconductor die 101 may be coupled to the top surface 100a of the substrate 100 by using methods known in the art, for example, SMT or adhesion. That is, the semiconductor die 101 is mounted on the top surface 100a of the substrate 100 with a "face-up" configuration. Preferably, the semiconductor die 101 may be electrically connected to the substrate 100 and the solder balls SB on the bottom surface 100b of the substrate 100 through the through silicon vias (TSVs) 110, which are mainly for power/ground connection of the semiconductor die 101 or HBM. Preferably, for example, the TSVs 110 may be power or ground TSVs for transmitting power or ground signals.

Preferably, the semiconductor package 1 further comprises a middle re-distribution layer (RDL) structure 200. Preferably, the middle RDL structure 200 may comprise dielectric layers 210 and interconnect structures 220. The interconnect structures 220 may be electrically connected to a plurality of RDL pads 230. Preferably, the top surface 101a of the semiconductor die 101 is electrically connected to the middle RDL structure 200 through connecting elements BP such as micro-bumps, metal pillars, or the like. Preferably, the gap between the middle RDL structure 200 and the top surface 101a of the semiconductor die 101 may be filled with an underfill material UF such as an epoxy resin, but is not limited thereto. Preferably, a plurality of through mold vias (TMVs) 122 may be disposed in the molding compound 120.

Preferably, the top package 30 is directly stacked on the middle RDL structure 200. Preferably, the top package 30 may comprise a memory component 300 such as a High-Bandwidth Memory (HBM) including multiple DRAM dies 301 stacked on one another and the stacked DRAM dies 301 are vertically interconnected by through silicon vias (TSVs) 310 and microbumps BT. Preferably, the memory component 300 may further comprise a DRAM base 302 which can include buffer circuitry and test logic. Preferably, the DRAM base 302 may include a DRAM controller. Preferably, the top package 30 may further comprise a molding compound 320 encapsulating the memory component 300. Preferably, the sidewall 30s of the top package 30 is vertically flush with the sidewall 20s of the bottom package 10.

Preferably, the memory component 300 may be aligned with the underlying semiconductor die 101 and disposed at or near the center of the semiconductor die 101 when viewed from above. Preferably, the center of the memory component 300 may be aligned with the center of the semiconductor die 101. When viewed from above, the memory component 300 completely overlaps with the underlying semiconductor die 101.

Preferably, the DRAM base 302 is electrically coupled to the middle RDL structure 200. Preferably, TSVs 110 of the semiconductor die 101 are provided for power or ground connection to the memory component 300. Power or ground signals may be transmitted to the solder balls SB on the bottom surface 100b of the substrate 100 via the shorter conductive path comprised of the interconnect structures 220 of the middle RDL structure 200, the connecting elements BP, the TSVs 110 of the semiconductor die 101, and the conductive traces lOOt of the substrate 100.

Signal connection between the memory component 300 and the semiconductor die 101 may be implemented through the middle RDL structure 200. More specifically, signals such as control signals or data signals may be transmitted between the memory component 300 and the semiconductor die 101 through the interconnect structures 220 of the middle RDL structure 200 and the connecting elements BP.

Optionally, some of the power or ground signals for the memory component 300 may be transmitted to the solder balls SB on the bottom surface 100b of the substrate 100 via the connecting elements BP, the interconnect structures 220 of the middle RDL structure 200, the TMVs 122, and the conductive traces lOOt of the substrate 100 to reduce the cost of TSV or power via as well as the die area.

Preferably, through vias 110v of the semiconductor die 101 are provided for power or ground connection to the circuit devices fabricated in the semiconductor die 101. Preferably, signals transmitted to or from the semiconductor die 101 may be implemented through the connection path comprised of the connecting elements BP, the interconnect structures 220 of the middle RDL structure 200, the TMVs 122, the conductive traces lOOt of the substrate 100, and the solder balls SB on the bottom surface of the 100b of the substrate 100.

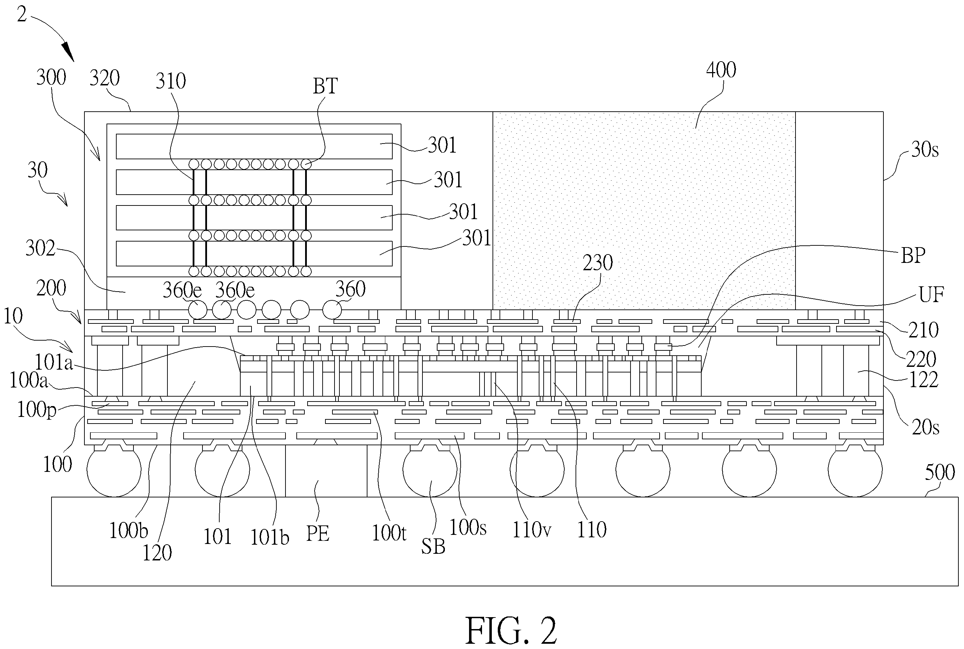

FIG. 2 is a schematic, cross-sectional diagram showing a variant semiconductor package with a TSV die and a dummy die in accordance with another embodiment of the disclosure, wherein like regions, layers or elements are designated by like numeral numbers or labels. As shown in FIG. 2, likewise, the semiconductor package 2 comprises a bottom package 10 and a top package 30 stacked on the bottom package 10. Preferably, for example, the bottom package 10 may comprise a substrate 100 and a semiconductor die 101, such as a logic die, mounted on a top surface 100a of the substrate 100. The semiconductor die (TSV die) 101 and the top surface 100a of the substrate 100 may be encapsulated by a molding compound 120.

Preferably, for example, the semiconductor die 101a may be a central processing unit (CPU), a graphics processing unit (GPU), a system-on-a-chip (SOC), a field-programmable gate array (FPGA), a microcontroller unit (MCU), a power management integrated circuit (PMIC) die, a radio frequency (RF) die, a sensor die, a micro-electro-mechanical-system (MEMS) die, or a signal processing die (e.g., digital signal processing (DSP) die), but is not limited thereto. Preferably, the bottom package 10 may include one or more logic dies.

Preferably, the top package 30 is directly stacked on the middle RDL structure 200. Preferably, likewise, the top package 30 may comprise a memory component 300 such as a High-Bandwidth Memory (HBM) including multiple DRAM dies 301 stacked on one another and the stacked DRAM dies 301 are vertically interconnected by through silicon vias (TSVs) 310 and microbumps BT. Preferably, the memory component 300 may further comprise a DRAM base 302 which can include buffer circuitry and test logic. Preferably, the DRAM base 302 may include a DRAM controller. Preferably, the top package 30 may further comprise a molding compound 320 encapsulating the memory component 300. Preferably, the sidewall 30s of the top package 30 is vertically flush with the sidewalls 20s of the bottom package 10.

Preferably, the memory component 300 is offset from the center of the underlying semiconductor die 101, Preferably, the center of the memory component 300 is not aligned with and is deviated from the center of the semiconductor die 101. When viewed from above, the memory component 300 may partially overlap with the underlying semiconductor die 101.

Preferably, the DRAM base 302 is electrically coupled to the middle RDL structure 200 through the connecting elements 360 such as conductive bumps or micro-bumps. An off-centered bump or pad design is implemented. Preferably, the connecting elements 360 are not arranged about a center of the semiconductor die 101. Preferably, all of the connecting elements 360 may be arranged adjacent to an edge of the semiconductor die 101. Preferably, some outer rows of the connecting elements 360, for example, the connecting elements 360e may be disposed beyond an edge of the semiconductor die 101.

Preferably, TSVs 110 of the semiconductor die 101 are provided for power or ground connection to the memory component 300. Power or ground signals may be transmitted to the solder balls SB on the bottom surface 100b of the substrate 100 via the shorter conductive path comprised of the interconnect structures 220 of the middle RDL structure 200, the connecting elements BP, the TSVs 110 of the semiconductor die 101, and the conductive traces lOOt of the substrate 100.

Signal connection between the memory component 300 and the semiconductor die 101 may be implemented through the middle RDL structure 200. More specifically, signals such as control signals or data signals may be transmitted between the memory component 300 and the semiconductor die 101 through the interconnect structures 220 of the middle RDL structure 200 and the connecting elements BP.

Optionally, some of the power or ground signals for the memory component 300 may be transmitted to the solder balls SB on the bottom surface 100b of the substrate 100 via the connecting elements BP, the interconnect structures 220 of the middle RDL structure 200, the TMVs 122, and the conductive traces lOOt of the substrate 100 to reduce the cost of TSV or power via as well as the die area.

Preferably, through vias 110v of the semiconductor die 101 are provided for power or ground connection to the circuit devices fabricated in the semiconductor die 101. Preferably, signals transmitted to or from the semiconductor die 101 may be implemented through the connection path comprised of the connecting elements BP, the interconnect structures 220 of the middle RDL structure 200, the TMVs 122, the conductive traces lOOt of the substrate 100, and the solder balls SB on the bottom surface of the 100b of the substrate 100.

Preferably, the top package 30 may further comprise at least one dummy die 400, such as a dummy silicon die. The memory component 300 and the dummy die 400 are mounted on the middle RDL structure 200 in a side-by-side manner. When viewed from above, the dummy die 400 may partially overlap with the underlying semiconductor die 101. The off-center configuration of the memory component 300 relative to the underlying semiconductor die 101 allows the placement of the dummy die 400 directly on the semiconductor die 101, which improves the thermal performance of the semiconductor package 2.

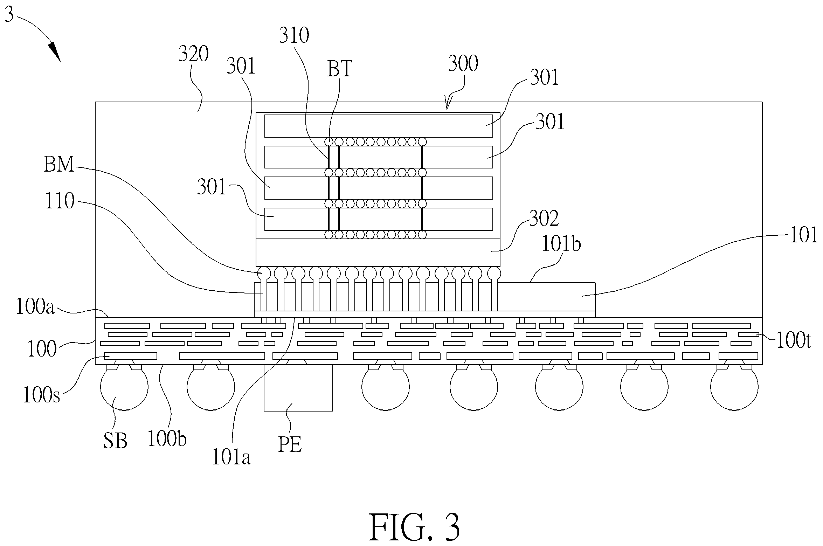

FIG. 3 is a schematic, cross-sectional diagram showing an exemplary semiconductor package with a TSV die in accordance with still another embodiment of the disclosure, wherein like regions, layers or elements are designated by like numeral numbers or labels. Preferably, the semiconductor package 3 may serve as a 3D semiconductor package assembly including at least two vertically stacked semiconductor dies or chip packages. As shown in FIG. 3, the semiconductor package 3 comprises a substrate 100 and a semiconductor die 101, such as a logic die, mounted on a top surface (die-attach surface) 100a of the substrate 100 in a flip-chip manner. Preferably, the semiconductor die 101 has a top surface (or active surface) 101a and a passive rear surface 101b. The circuit elements such as transistors are fabricated on or near the top surface 101a of the semiconductor die 101.

Preferably, for example, the substrate 100 may be a RDL substrate that has a thinner thickness. It is to be understood that the substrate 100 may be a single layer or a multi-layer structure. Preferably, for example, the substrate 100 may comprise a plurality of conductive traces lOOt interconnecting the active surface 101a of the semiconductor die 101 with the ball pads 100s distributed on or near the bottom surface 100b of the substrate 100. The solder balls SB are disposed on the ball pads 100s, respectively. Preferably, at least one passive device PE may be mounted on the bottom surface 100b of the substrate 100 using surface mount technique.

Preferably, the semiconductor die 101 is mounted on the top surface 100a of the substrate 100 with a "face-down" configuration with its top surface (or active surface) 101a directly facing the substrate 100. Preferably, likewise, the semiconductor die 101 may be electrically connected to the substrate 100 and the solder balls SB on the bottom surface 100b of the substrate 100 through the through silicon vias (TSVs) 110, which are mainly for power/ground connection of the semiconductor die 101 or HBM. Preferably, for example, the TSVs 110 may be power or ground TSVs for transmitting power or ground signals.

Preferably, a memory component 300 such as HBM is directly mounted on the semiconductor die 101. Preferably, the memory component 300 may be electrically connected to the semiconductor die 101 through the connecting elements BM such as micro-bumps or metal pillars. Preferably, the memory component 300 may comprise multiple DRAM dies 301 stacked on one another. The stacked DRAM dies 301 are vertically interconnected by through silicon vias (TSVs) 310 and micro-bumps BT. Preferably, the memory component 300 may further comprise a DRAM base 302 which can include buffer circuitry and test logic. Preferably, the DRAM base 302 may include a DRAM controller. Preferably, the semiconductor die 101 and the memory component 300 may be packaged in one unified molding compound 320. Preferably, the semiconductor package 3 may be mounted on a printed circuit board (not shown in this figure) or any carrier substrate known in the art.

Preferably, the memory component 300 may be offset from the center of the underlying semiconductor die 101, That is, the center of the memory component 300 is not aligned with and is deviated from the center of the semiconductor die 101. Preferably, signals such as power or ground may be transmitted to the solder balls SB on the bottom surface 100b of the substrate 100 via the shorter conductive path comprised of the connecting elements BM, the TSVs 110 of the semiconductor die 101, and the conductive traces lOOt of the substrate 100. Optionally, the DRAM base 302 may be electrically connected to a middle RDL structure between the semiconductor die 101 and the memory component 300 as described in FIG. 1.

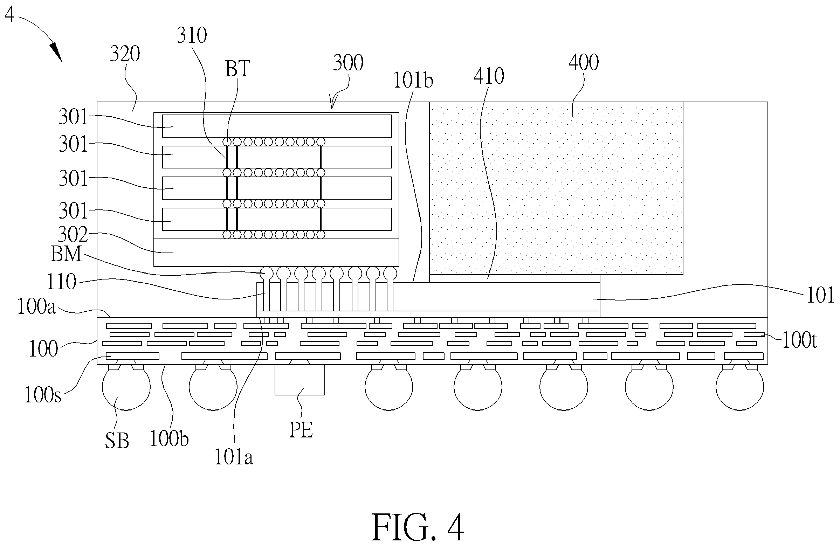

FIG. 4 is a schematic, cross-sectional diagram showing an exemplary semiconductor package with a TSV die and a dummy die in accordance with still another embodiment of the disclosure, wherein like regions, layers or elements are designated by like numeral numbers or labels. Preferably, the semiconductor package 4 may serve as a 3D semiconductor package assembly including at least two vertically stacked semiconductor dies or chip packages. As shown in FIG. 4, likewise, the semiconductor package 4 comprises a substrate 100 and a semiconductor die 101, such as a logic die, mounted on a top surface (die-attach surface) 100a of the substrate 100 in a flip-chip manner. Preferably, the semiconductor die 101 has a top surface (or active surface) 101a and a passive rear surface 101b. The circuit elements such as transistors are fabricated on or near the top surface 101a of the semiconductor die 101.

Preferably, for example, the substrate 100 may be a RDL substrate that has a thinner thickness. It is to be understood that the substrate 100 may be a single layer or a multi-layer structure. Preferably, for example, the substrate 100 may comprise a plurality of conductive traces lOOt interconnecting the active surface 101a of the semiconductor die 101 with the ball pads 100s distributed on or near the bottom surface 100b of the substrate 100. The solder balls SB are disposed on the ball pads 100s, respectively. Preferably, at least one passive device PE may be mounted on the bottom surface 100b of the substrate 100 using surface mount technique.

Preferably, the semiconductor die 101 is mounted on the top surface 100a of the substrate 100 with a "face-down" configuration with its top surface (or active surface) 101a directly facing the substrate 100. Preferably, likewise, the semiconductor die 101 may be electrically connected to the substrate 100 and the solder balls SB on the bottom surface 100b of the substrate 100 through the through silicon vias (TSVs) 110, which are mainly for power/ground connection of the semiconductor die 101 or HBM. Preferably, for example, the TSVs 110 may be power or ground TSVs for transmitting power or ground signals.

Preferably, the memory component 300 such as HBM is directly mounted on the semiconductor die 101. Preferably, the memory component 300 may be electrically connected to the semiconductor die 101 through the connecting elements BM such as micro-bumps or metal pillars. Preferably, the memory component 300 may comprise multiple DRAM dies 301 stacked on one another. The stacked DRAM dies 301 are vertically interconnected by through silicon vias (TSVs) 310 and micro-bumps BT. Preferably, the memory component 300 may further comprise a DRAM base 302 which can include buffer circuitry and test logic. Preferably, the DRAM base 302 may include a DRAM controller.

Preferably, the memory component 300 may be offset from the center of the underlying semiconductor die 101, That is, the center of the memory component 300 is not aligned with and is deviated from the center of the semiconductor die 101. When viewed from above, the memory component 300 may only partially overlap with the underlying semiconductor die 101. An off-centered bump or pad design is implemented. Preferably, the connecting elements BM are not arranged about a center of the semiconductor die 101. Preferably, all of the connecting elements BM may be arranged adjacent to an edge of the semiconductor die 101. As shown in FIG. 4, the memory component 300 may protrude beyond a sidewall of the semiconductor die 101. Preferably, signals such as power or ground may be transmitted to the solder balls SB on the bottom surface 100b of the substrate 100 via the shorter conductive path comprised of the connecting elements BM, the TSVs 110 of the semiconductor die 101, and the conductive traces lOOt of the substrate 100. Optionally, the DRAM base 302 may be electrically connected to a middle RDL structure between the semiconductor die 101 and the memory component 300 as described in FIG. 1.

Preferably, at least one dummy die 400 such as a dummy silicon die is disposed on the semiconductor die 101. Preferably, for example, the dummy die 400 may be mounted to the semiconductor die 101 by using an adhesive layer 410, but is not limited thereto. The memory component 300 and the dummy die 400 are mounted on the semiconductor die 101 in a side-by-side manner. When viewed from above, the dummy die 400 may partially overlap with the underlying semiconductor die 101. The off-center configuration of the memory component 300 relative to the underlying semiconductor die 101 allows the placement of the dummy die 400 directly on the semiconductor die 101, which improves the thermal performance of the semiconductor package 2. Preferably, the semiconductor die 101, the memory component 300, and the dummy die 400 may be packaged in one unified molding compound 320. Preferably, the semiconductor package 4 may be mounted on a printed circuit board (not shown in this figure) or any carrier substrate known in the art.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package, comprising:
a bottom package (10) comprising a substrate (100) and a semiconductor die (101) mounted on a top surface (100a) of the substrate (100), wherein the semiconductor die (101) has an active surface (101a) and a rear surface (101b) coupled to the top surface (100a) of the substrate (100), wherein the semiconductor die (101) comprises through silicon vias (110), and wherein the semiconductor die (101) and the top surface (100a) of the substrate (100) are encapsulated by a first molding compound (120);
a top package (30) stacked on the bottom package (10), wherein the top package (30) comprises a memory component (300); and
a middle re-distribution layer, in the following also referred to as RDL, structure (200) disposed between the top package (30) and the bottom package (10), wherein the active surface (101a) of the semiconductor die (101) is directly connected to the middle RDL structure (200) through connecting elements (BP), wherein the middle RDL structure (200) comprises dielectric layers (210) and interconnect structures (220), wherein the memory component (300) is electrically connected to the substrate (100) via the interconnect structures (220) of the middle RDL structure (200) and the through silicon vias (110) of the semiconductor die (101).

2. The semiconductor package according to claim 1, wherein the semiconductor die (101) comprises a central processing unit, in the following also referred to as CPU, a graphics processing unit, in the following also referred to as GPU, a system-on-a-chip, in the following also referred to as SOC, a field-programmable gate array, in the following also referred to as FPGA, a microcontroller unit, in the following also referred to as MCU, a power management integrated circuit, in the following also referred to as PMIC, die, a radio frequency, in the following also referred to as RF, die, a sensor die, a micro-electro-mechanical-system, in the following also referred to as MEMS, die, or a signal processing die; and/or
wherein the substrate (100) is a re-distribution layer, in the following also referred to as RDL, substrate.

3. The semiconductor package according to claim 1 or 2, wherein the substrate (100) comprises a plurality of connection pads (100p) disposed on or near the top surface (100a) of the substrate (100), a plurality of conductive traces (100t) interconnecting the plurality of connection pads (100p) with a plurality of ball pads (100s) distributed on or near a bottom surface (100b) of the substrate (100);
wherein preferably a plurality of solder balls (SB) is disposed on the plurality of ball pads (100s), respectively.

4. The semiconductor package according to any one of claims 1 to 3, wherein power or ground to the memory component (300) is provided through the through silicon vias (110).

5. The semiconductor package according to any one of claims 1 to 4, wherein the connecting elements (BP) comprises micro-bumps; and/or
wherein a gap between the middle RDL structure (200) and the active surface (101a) of the semiconductor die (101) is filled with an underfill material (UF); and/or
wherein a plurality of through mold vias (122) is disposed in the first molding compound (120).

6. The semiconductor package according to any one of claims 1 to 5, wherein the memory component (300) is a High-Bandwidth Memory, in the following also referred to as HBM, including multiple DRAM dies (301) stacked on one another, wherein the stacked DRAM dies (301) are vertically interconnected.

7. The semiconductor package according to claim 6, wherein the memory component (300) further comprises a DRAM base (302);
wherein preferably the DRAM base (302) is electrically coupled to the middle RDL structure (200), wherein power or ground signals are transmitted to the solder balls (SB) on the bottom surface (100b) of the substrate (100) via a conductive path comprised of the interconnect structures (220) of the middle RDL structure (200), the connecting elements (BP), the through silicon vias (110) of the semiconductor die (101), and the conductive traces (100t) of the substrate (100).

8. The semiconductor package according to any one of claims 1 to 7, further comprising:
a second molding compound (320) encapsulating the memory component (300).

9. The semiconductor package according to any one of claims 1 to 8, wherein the memory component (300) is aligned with the semiconductor die (101) and disposed at or near the center of the semiconductor die (101) when viewed from above; and/or
wherein a sidewall (30s) of the top package (30) is vertically flush with a sidewall (20s) of the bottom package (10).

10. The semiconductor package according to any one of claims 1 to 9, wherein the top package (30) further comprises a dummy die (400).

11. A semiconductor package, comprising:
a substrate (100);
a semiconductor die (101) mounted on a top surface (100a) of the substrate (100) in a flip-chip manner, wherein the semiconductor die (101) has an active surface (101a) and a passive rear surface (101b), wherein the semiconductor die (101) comprises through silicon vias (110); and
a memory component (300) directly mounted on the semiconductor die (101), wherein the memory component (300) is electrically connected to the semiconductor die (101) through connecting elements (BM), and wherein the semiconductor die (101) and the memory component (300) are packaged in a unified molding compound (320).

12. The semiconductor package according to claim 11, wherein the substrate (100) comprises a plurality of conductive traces (100t) interconnecting the active surface (101a) of the semiconductor die (101) with ball pads (100s) distributed on or near a bottom surface (100b) of the substrate (100);
wherein preferably solder balls (SB) are disposed on the ball pads (100s), respectively;
wherein further preferably power or ground signals are transmitted to the solder balls (SB) on the bottom surface (100b) of the substrate (100) via a conductive path comprised of the connecting elements (BM), the through silicon vias (110) of the semiconductor die (101), and the conductive traces (100t) of the substrate (100).

13. The semiconductor package according to claim 11 or 12, wherein the memory component (300) is a High-Bandwidth Memory, in the following also referred to as HBM, including multiple DRAM dies (301) stacked on one another, wherein the stacked DRAM dies (301) are vertically interconnected by through silicon vias (310) and microbumps (BT);
wherein preferably the memory component (300) further comprises a DRAM base (302).

14. The semiconductor package according to any one of claims 11 to 13, wherein the memory component (300) is offset from a center of the semiconductor die (101).

15. The semiconductor package according to any one of claims 11 to 14 further comprising:
a dummy die (400) disposed on the semiconductor die (101), which is packaged in the unified molding compound (320).
